Europäisches Patentamt

European Patent Office

Office européen des brevets

(19)

(11) EP 0 661 816 B1

(12) **FASCICULE DE BREVET EUROPEEN**

(45) Date de publication et mention
de la délivrance du brevet:
**06.05.1999 Bulletin 1999/18**

(51) Int Cl.$^6$: **H03L 7/187**

(21) Numéro de dépôt: **94402991.7**

(22) Date de dépôt: **22.12.1994**

(54) **Synthétiseur de fréquences à boucle unique et ensemble électronique comportant un tel synthétiseur**

Einzelschleifenfrequenzsynthetisierer und einen solchen Synthetisierer enthaltende elektronische Anordnung

Single-loop frequency synthesizer and electronic assembly comprising such a synthesizer

(84) Etats contractants désignés:
**DE ES FR GB IT SE**

(30) Priorité: **28.12.1993 FR 9315741**

(43) Date de publication de la demande:
**05.07.1995 Bulletin 1995/27**

(73) Titulaire: **THOMSON-CSF
75008 Paris (FR)**

(72) Inventeurs:
• **Brunet, Elie
F-92402 Courbevoie Cédex (FR)**
• **Brasselet, Jean-Noel
F-92402 Courbevoie Cédex (FR)**

• **Souchard, Eric
F-92402 Courbevoie Cédex (FR)**

(74) Mandataire: **Courtellemont, Alain et al
Thomson-CSF Propriété Intellectuelle,
13, Avenue du Président Salvador Allende
94117 Arcueil Cédex (FR)**

(56) Documents cités:
**US-A- 4 464 638          US-A- 5 184 093**

• **PROCEEDINGS OF THE 1993 IEEE
INTERNATIONAL FREQUENCY CONTROL
SYMPOSIUM, 2 Juin 1993, NEW YORK pages 261
- 269, XP420142 THOMAS J. ENDRES ET AL.
'INDUCED END-OF-LIFE ERRORS IN A FAST
SETTLING PLL'**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

## Description

La présente invention se rapporte aux synthétiseurs de fréquences à verrouillage de phase et concerne plus particulièrement les synthétiseurs à boucle unique.

Les synthétiseurs de fréquences sont connus ; ils sont employés, en particulier, en radiocommunications comme source du signal à radiofréquence dans la chaîne d'émission et comme oscillateur local de transposition dans la chaîne de réception. Dans les systèmes de radiocommunication à évasion de fréquence où la fréquence est changée selon un certain rythme et une certaine loi, le rythme du changement de fréquence, quantifiée en nombre de sauts par seconde, est borné par l'inverse du temps mis par le synthétiseur pour aller d'une fréquence à une autre fréquence. Le besoin de synthétiseurs toujours plus rapides a conduit à réaliser des synthétiseurs à boucles multiples, par exemple à trois boucles : une boucle principale qui génère un premier signal dont la fréquence peut varier avec des pas de, par exemple, 1 MHz et plus, une boucle secondaire avec diviseur de sortie qui génère un second signal dont la fréquence et les pas de variation sont réglables indépendamment de ceux du premier signal et sont par exemple de l'ordre de cinquante fois plus faibles du fait de la division par le diviseur de sortie, et une boucle d'addition qui effectue la somme du premier et du second signal. L'inconvénient de ces synthétiseurs à boucles multiples est qu'ils nécessitent beaucoup d'oscillateurs variables; ainsi pour un oscillateur à trois boucles il faut neuf oscillateurs différents pour couvrir deux octaves du fait qu'un même oscillateur ne peut couvrir plus d'une demi-octave mais que dans la boucle secondaire il est possible, au lieu de changer d'oscillateur, de changer le rapport de division du diviseur de sortie; or les oscillateurs variables consomment du courant, prennent de la place, sont coûteux et risquent d'entraîner des signaux parasites dans le synthétiseur, s'ils ne sont pas suffisamment découplés entre eux.

La présente invention a pour but d'éviter ou, pour le moins, de réduire ces inconvénients.

Ceci est obtenu en associant une boucle unique à un dispositif de synthèse numérique directe et en injectant, dans la boucle unique, grâce à un mélangeur, le signal élaboré par le dispositif de synthèse numérique directe.

Selon l'invention il est proposé un synthétiseur de fréquences à boucle unique pour fournir une fréquence synthétisée pouvant s'écrire

$$\left(N + \frac{K}{M}\right) Fr$$

où Fr est une fréquence, N, K et M des nombres entiers avec N et M positifs et K inférieur à M en valeur absolue, ce synthétiseur comportant un oscillateur de référence pour fournir un signal à la fréquence Fr, caractérisé en ce qu'il comporte un mélangeur avec une première et une seconde entrée et une sortie et un dispositif de synthèse numérique directe, en ce que le mélangeur est disposé en série dans la boucle par sa première entrée et sa sortie et en ce que le dispositif de synthèse numérique directe à une sortie reliée à la seconde entrée du mélangeur et élabore, à partir du signal à fréquence Fr, un signal de fréquence

$$\left(Ns + \frac{K}{M}\right) Fr$$

où Ns est un entier positif petit devant N.

La présente invention sera mieux comprise et d'autres caractéristiques apparaîtront à l'aide de la description ci-après et des figures s'y rapportant qui représentent:

- la figure 1, un synthétiseur à boucle unique selon l'art antérieur,
- la figure 2, un synthétiseur à boucle unique selon l'invention,
- les figures 3 et 4 des détails de réalisation relatifs à des variantes au synthétiseur selon la figure 2.

Sur les différentes figures les éléments correspondants sont désignés par les mêmes références.

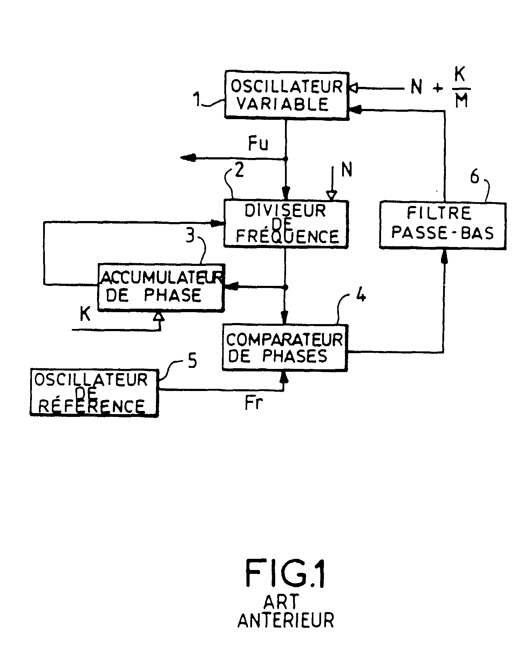

La figure 1 représente un synthétiseur de fréquences à boucle unique selon l'art antérieur. Dans ce synthétiseur un oscillateur variable, 1, comportant une entrée de précommande en tension sur laquelle est appliqué une tension fonction de $N + \frac{K}{M}$, la signification de $N + \frac{K}{M}$ apparaîtra plus loin, et une entrée de commande en tension, fournit sur une sortie de signal un signal Fu qui constitue à la fois le signal de sortie du synthétiseur et le signal d'entrée pour un diviseur de fréquence 2. La sortie du diviseur de fréquence est reliée à la seconde entrée d'un comparateur de phases 4 qui reçoit sur sa première entrée le signal de sortie de fréquence Fr délivré par un oscillateur de référence, 5, l'oscillateur 5 est constitué par un oscillateur à quartz compensé en température. Le diviseur de fréquence 2 comporte une entrée de programmation pour donner à son rapport de division une valeur N où N est un entier positif, et une entrée de commande pour faire passer son rapport de division de la valeur N à la valeur N+1, selon qu'un 0 ou un 1 est appliqué sur cette entrée de commande; un accumulateur de phase modulo M, 3, où M est un entier positif supérieur à 1, couple la sortie du diviseur 2 à son entrée de commande. La sortie du comparateur de phases est couplée par un filtre passe-bas, 6, à l'entrée de commande de l'oscillateur variable 1.

L'accumulateur de phase 3 comporte une entrée de commande sur laquelle est appliqué un code de commande K représentant un nombre entier compris entre 0 inclus et M-1 inclus. Ainsi commandé, l'accumulateur de phase 3 délivre sur sa sortie K impulsions pour M périodes du signal de sortie du diviseur 2. Ainsi, lorsque le synthétiseur est synchronisé, c'est-à-dire quand le signal de sortie du diviseur 2 est à la fréquence Fr du signal de sortie de l'oscillateur de référence 5, la fréquence Fr à la sortie du diviseur 2 est égale à la fréquence d'entrée Fu du diviseur, divisée par $N + \frac{K}{M}$, ce qui revient à écrire

$$Fu = \left(N + \frac{K}{M}\right)Fr$$

En considérant la fréquence Fr comme la fréquence unitaire, N représente la partie entière de Fu et $\frac{K}{M}$ sa partie fractionnaire. Et le plus petit incrément ou pas de fréquence qu'il est possible d'obtenir avec le synthétiseur selon la figure 1, est $\frac{Fr}{M}$.

L'acquisition d'une fréquence par la boucle peut être considérée comme s'effectuant selon deux étapes successives: une première étape d'approche, de durée t1, pendant laquelle la tension de commande de l'oscillateur variable varie de façon important et une seconde étape de verrouillage en phase, de durée t2, pendant laquelle les variations de la tension de commande de l'oscillateur variable sont faibles. Le prépositionnement de la tension de commande de l'oscillateur variable permet de faire tendre t1 vers 0. La durée t2 de la seconde période est une fonction inverse de la fréquence de coupure de la boucle et est principalement liée à la fréquence $\frac{Fr}{M}$ et à l'atténuation sur cette fréquence. A titre d'exemple, avec les valeurs suivantes

$$\frac{Fr}{M} = 25 \text{ kHz} = 1/(40\mu s),$$

80 dBc pour les raies parasites, c'est-à-dire 80 décibels d'atténuation sur les raies de synthèse par rapport au signal à fréquence Fu

qui sont des valeurs habituelles pour ce genre de synthétiseur, le temps d'acquisition est de l'ordre de 2 ms soit 2 000µs/40µs = 50 fois la période correspondant au pas de fréquence. Un tel temps d'acquisition est trop long pour beaucoup d'applications des synthétiseurs de fréquences. Pour y remédier des synthétiseurs à boucles multiples ont été conçus dont les inconvénients ont été indiqués dans ce qui précède.

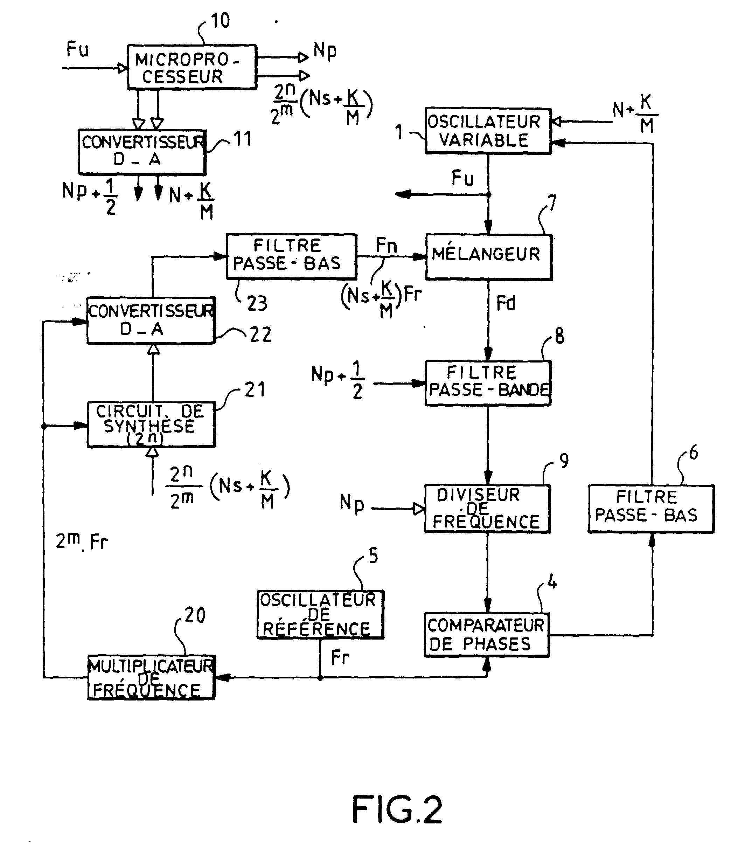

La figure 2 représente un synthétiseur de fréquence à boucle unique dans lequel la boucle n'élabore que des pas de fréquence d'une valeur égale à la fréquence de référence Fr tandis que, à l'extérieur de la boucle, sont élaborés, par synthèse numérique, des pas de fréquence beaucoup plus petits.

La boucle unique comporte les éléments 1, 4 et 6 à 9 selon la figure 2; la synthèse numérique est effectuée grâce aux éléments 21 à 23 de la figure 2. Cette même figure montre un oscillateur de référence 5 qui délivre un signal de fréquence Fr, et un multiplicateur de fréquence, 20, qui reçoit une partie du signal de fréquence Fr pour délivrer un signal de fréquence $2^m.Fr$ où m est un entier positif le signal de fréquence $2^m \cdot Fr$ constitue le signal d'horloge pour la synthèse numérique.

La boucle unique selon la figure 2 se distingue de celle selon la figure 1 en ce que

- la division fractionnaire des circuits 2, 3, est remplacée par une division de rapport entier fixe Np obtenue par un diviseur de fréquence 9 ayant une entrée de commande de son rapport de division sur laquelle est appliqué un code représentatif de la valeur Np,

- l'introduction, entre la sortie de signal de l'oscillateur 1 et le diviseur 9, d'un mélangeur 7 suivi d'un filtre passe-bande, 8, qui est réglé en fonction de la valeur $Np + \frac{1}{2}$.

Le mélangeur 7 a une première entrée reliée à la sortie de l'oscillateur 1, une seconde entrée et une sortie reliée à une entrée de signal du filtre 8. Le filtre passe-bande 8 est constitué de cellules L-C à condensateurs réglables de type varicaps; le centrage de la bande passante de ce filtre est assuré par préposition en tension des varicaps.

Les éléments 21 à 23 qui réalisent la synthèse numérique sont, de façon classique, constitués respectivement par un circuit de synthèse digitale directe, 21, suivi d'un convertisseur digital-analogique, 22, lui-même suivi par un filtre passe-bas, 23, dont la sortie est reliée à la seconde entrée du mélangeur 7.

Le circuit de synthèse digitale directe 21, de résolution $2^n$, a une entrée de signal d'horloge pour recevoir le signal à la fréquence $2^m.Fr$ et une entrée de commande pour recevoir un signal qui peut s'écrire sous la forme

$$\frac{2^n}{2^m}\left(Ns+\frac{K}{M}\right) \, ;$$

la signification de Ns, K et M apparaîtra dans ce qui suit. Le convertisseur digital-analogique 22 a une entrée de signal d'horloge pour recevoir le signal à la fréquence $2^m.Fr$.

La synthèse numérique avec conversion digitale-analogique et filtrage, ainsi décrite, fournit, à la sortie du filtre 23, un signal analogique de fréquence Fd avec

$$Fn = \left[\frac{2^n}{2^m}\left(Ns+\frac{K}{M}\right)\right]\frac{2^m}{2^n}\,Fr$$

$$Fn = \left(Ns+\frac{K}{M}\right)Fr$$

En appelant Fu la fréquence désirée pour le signal de sortie de l'oscillateur variable 1 et Fd la fréquence de sortie du mélangeur 7, il vient

$$Fu=Fd+Fn$$

dans la mesure où, à la sortie du mélangeur c'est la fréquence obtenue par soustraction entre les fréquences d'entrée qui est utilisée.

Quand l'asservissement de la boucle est obtenu, les signaux sur les deux entrées du comparateur de phases 4 sont à une même fréquence c'est-à-dire à la fréquence Fr; ainsi, compte tenu du rapport de division Np du diviseur 9, la fréquence Fd peut s'écrire Fd=Np.Fr.

La fréquence de sortie de l'oscillateur 1 s'écrit

$$Fu = Fd+Fn$$

$$= Np.Fr + \left(Ns+\frac{K}{M}\right)Fr$$

$$= \left(Np+Ns+\frac{K}{M}\right)Fr$$

et, en posant Np+Ns=N, il vient

$$Fu = \left(N+\frac{K}{M}\right)Fr$$

c'est cette même formule qui donnait Fu dans le cas de la figure 1 et c'est ce qui explique que la valeur pour réaliser le prépositionnement de l'oscillateur variable 1 de la figure 2 ait été notée $N+\frac{K}{M}$.

Comme il a été annoncé la boucle de la figure 2 n'élabore donc que des pas de valeur Fr, contre des pas de valeur $\frac{Fr}{M}$ pour la boucle selon la figure 1, ce qui fait que la boucle selon la figure 2 a un temps d'acquisition M fois plus court que la boucle selon la figure 1. Il est à noter à ce sujet que la valeur M à prendre en compte est la valeur dans le synthétiseur selon la figure 2 et qu'elle est nettement plus grande que dans le cas de la figure 1 où, selon l'exemple de réalisation dont il a été question, elle n'était que de 40 ; dans l'exemple de réalisation selon la figure 2, M sera égal à $2^{27}$.

Il est à noter également que le temps d'acquisition de la synthèse numérique étant extrêmement faible, de l'ordre de moins d'une dizaine de cycles d'horloge, c'est-à-dire dans l'exemple décrit de l'ordre de moins d'une dizaine de périodes du signal à fréquence $2^m.Fr$, ce temps d'acquisition peut pratiquement être négligé vis-à-vis du temps d'acquisition de la boucle.

Il est à remarquer qu'une conception toute numérique de la synthèse n'est pas envisageable pour des fréquences supérieures à quelques dizaines de mégahertz. Il y a deux raisons à cela

-    les limites actuelles de la technologie; les convertisseurs numériques-analogiques à des fréquences de l'ordre du gigahertz et plus ont une résolution inférieure ou égale à 5 bits ce qui correspond environ à 5x6=30 dBc pour les raies parasites, c'est-à-dire à 30 décibels d'atténuation sur les raies parasites par rapport au signal à fréquence utile; par contre pour une synthèse d'une fréquence de l'ordre de 10MHz il existe des convertisseurs numériques-analogiques ayant une résolution de 12 bits soit environ 12x6=72 dBc pour les raies parasites,

-    la qualité spectrale exigée des synthétiseurs en bruit de phase large bande, aussi appelé bruit plancher, noise floor dans la littérature anglo-saxonne est de l'ordre de 170 dBc ; or une synthèse numérique bute sur le bruit de sa propre technologie car ce bruit se situe, au mieux, à de l'ordre de 130 à 140 dBc.

L'exemple numérique qui est étudié ci-après va permettre de préciser le fonctionnement du synthétiseur selon la figure 2.

Les données de départ sont : une fréquence de référence Fr=1 MHz, et une résolution de $2^n=2^{32}$ ce qui est une valeur courante pour les circuits de synthèse digitale directe du commerce. Le but à atteindre est d'asservir l'oscillateur 1 dans sa bande de fréquences de fonctionnement.

La boucle n'étant, comme il a été vu, capable que de réaliser des pas de valeur Fr= 1 MHz, par modification de la valeur entière du rapport de division Np du diviseur 9, les valeurs intermédiaires sont obtenues par la synthèse numérique qui fournit le signal Fn ; pour cela les circuits 21, 22 ont été choisis pour pouvoir travailler entre 8 et 9 MHz, étant entendu que d'autres valeurs de bande de fonctionnement auraient pu également convenir à condition que la bande choisie s'étende sur au moins 1 MHz. Avec, dans l'exemple décrit, Fn compris entre 8 et 9 MHz, la fréquence de l'horloge, $2^m.Fr$, doit être, d'après Shannon, au moins le double c'est-à-dire qu'il faut avoir

$$2^m.1 \text{ MHz} \geq 9 \text{ MHz}$$

cette condition est largement satisfaite dans l'exemple décrit où m = 5 ce qui donne $2^m=32$. Ainsi la synthèse digitale permettant d'effectuer des pas de $\frac{2^m}{2^n}Fr$, pour l'utiliser pleinement M est pris égal à $2^{n-m}=2^{27}$.

Soit maintenant à élaborer un signal Fu compris dans la bande de fréquences de l'oscillateur 1, ayant, par exemple, comme valeur 225,512 MHz. Np sera pris égal à 217 de manière que la fréquence Fn à élaborer par synthèse numérique ait une valeur, 8,512 MHz, comprise dans la bande 8-9 MHz. Il reste à déterminer les valeurs Ns et K du synthétiseur monoboucle selon la figure 2.

Pour Fu=217 MHz + 8 MHz = 225 MHz, la fréquence Fn vaut 8 MHz et K est égal à 0, ce qui permet d'écrire

$$Fn = 8 \text{ MHz} = Ns.1 \text{ MHz}$$

d'où Ns=8.

Il est à noter que d'une manière générale Ns sera petit devant Np et donc devant N, la synthèse numérique étant utilisée à des fréquences nettement plus faibles que les fréquences élaborées dans la boucle du synthétiseur.

Pour Fu=225,512 MHz, Ns vaut toujours 8 et la partie fractionnaire de Fu est donnée par le terme en $\frac{K}{M}$ :

$$0,512 \text{MHz} = \frac{K}{2^{27}}.1 \text{ MHz}$$

ce qui donne K =$0,512.2^{27}$, c'est-à-dire que le signal de commande du circuit 21 est donné par

$$2^{27}(8+0{,}512)$$

Les différentes valeurs nécessaires au fonctionnement du synthétiseur à boucle unique qui vient d'être décrit sont calculées par un microprocesseur 10 en fonction de la fréquence Fu à obtenir ; ce microprocesseur fournit les valeurs numériques

$$\frac{2^n}{2^m}\left(Ns+\frac{K}{M}\right),$$

Np, Np $+\frac{1}{2}$ et N $+\frac{K}{M}$ et un convertisseur digital-analogique 11 convertit Np $+\frac{1}{2}$ et N $+\frac{K}{M}$ en valeurs analogiques.
Il est à noter que le filtre passe-bande, 8, a sa bande de fréquence centrée sur

$$\left(Np+\frac{1}{2}\right)Fr$$

c'est-à-dire sur le battement inférieur du premier ordre entre Fu et Fn afin de supprimer tous les autres produits de mélange par le mélangeur 7, et donc de permettre un bon fonctionnement du diviseur 9 ; dans le cas où la boucle utiliserait la fréquence Fd = Fu+Fn le filtre aurait été centré sur

$$\left(Np-\frac{1}{2}\right)Fr.$$

Le fonctionnement du synthétiseur selon la figure 2 nécessite que le diviseur 9 ne soit jamais "aveugle" c'est-à-dire qu'il reçoive toujours un signal d'entrée. Il est possible d'obtenir ce résultat en prenant un certain nombre de précautions :

réalisation de l'oscillateur 1 et du filtre 8 pour que leurs dérives en température se compensent,
prépositionnement de l'oscillateur 1 et du filtre 8 à partir d'un même convertisseur numérique analogique.

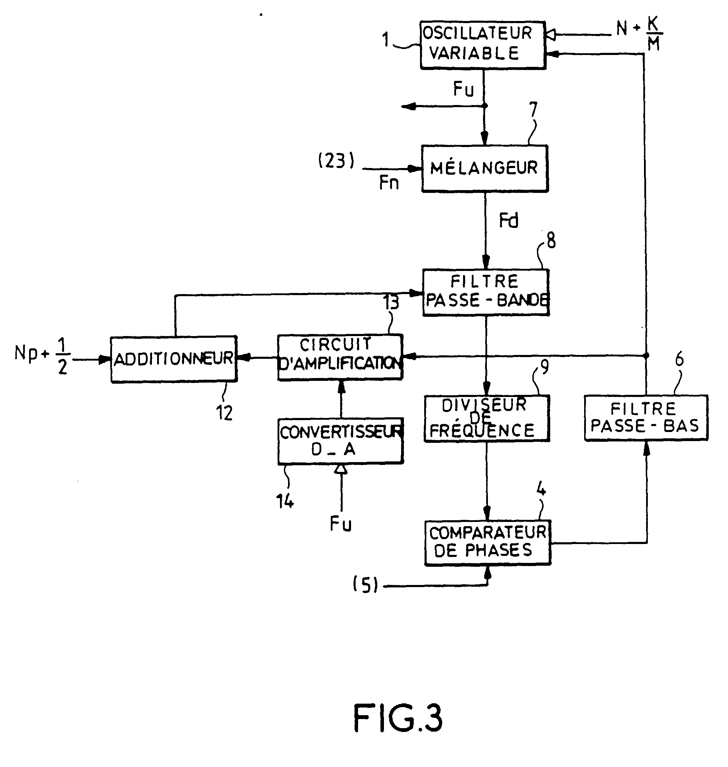

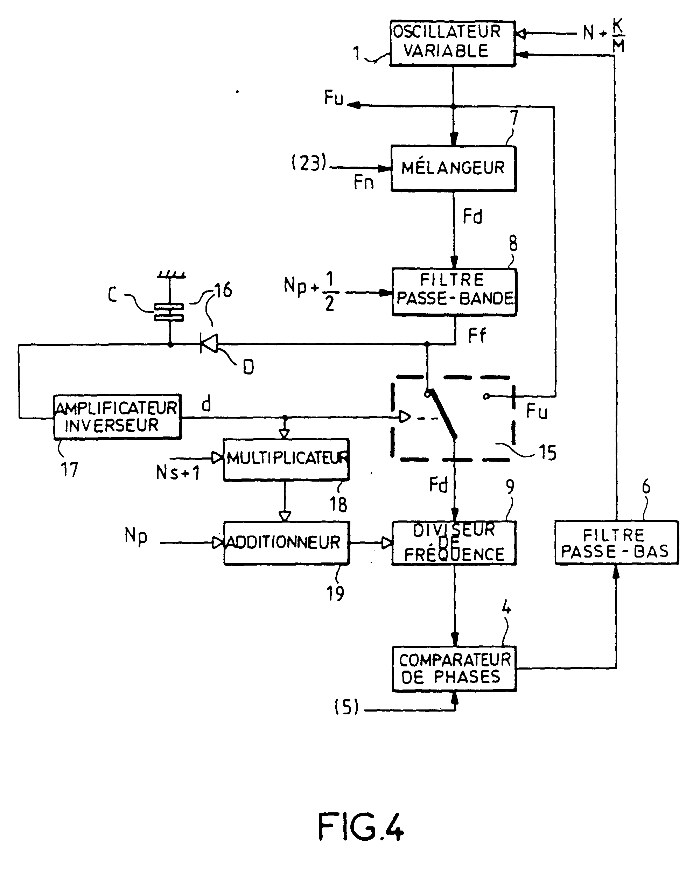

Dans le cas où ces précautions seraient insuffisantes il est possible de modifier le schéma selon la figure 2 comme indiqué sur la figure 3. La modification consiste à faire que le prépositionnement du filtre passe-bande 8 dépende de la tension de commande de l'oscillateur 1. Pour cela le signal de commande du filtre 9 est obtenu à la sortie d'un additionneur analogique, 12, à deux entrées qui reçoit sur sa première entrée le signal analogique Np $+\frac{1}{2}$ et sur sa seconde entrée le signal de sortie d'un circuit d'amplification à gain réglable 13 ; le circuit 13 a une entrée de signal reliée à la sortie du filtre passe-bas 6 et une entrée de commande reliée à la sortie d'un convertisseur digital-analogique 14 qui reçoit sur son entrée la valeur numérique Fu correspondant à la fréquence à obtenir. La fonction de transfert du convertisseur digital-analogique 14 est établie lors de la mise au point du synthétiseur.
En plus ou indépendamment des précautions dont il a été question plus avant et de la variante selon la figue 3, la figure 4 propose une autre modification au schéma de la figure 2 pour éviter que le diviseur 9 soit "aveugle". Cette modification consiste à relier directement la sortie de l'oscillateur 1 à l'entrée du diviseur 9 tant que le filtre 8 ne fournit pas de signal de sortie et, pendant cette étape préliminaire qui sera appelée étape d'approche, à donner au diviseur 9 un rapport de division égal à Np+Ns+1. Ainsi, pendant l'étape d'approche, le signal de fréquence Fn, élaboré par synthèse numérique, n'est pas pris en compte dans la boucle du synthétiseur et cette boucle tend à produire un signal Fu de fréquence (Np+Ns+1)Fr.
Comme il ressort de la figure 4, les modifications à apporter au synthétiseur selon la figure 2 pour effectuer une étape d'approche afin d'amener l'oscillateur 1 dans une plage de bon fonctionnement de la boucle consistent

- à intercaler entre la sortie du filtre 8 et l'entrée de signal du diviseur 9 un commutateur électronique, 15, à deux positions dont le premier accès, le second accès et le point commun sont respectivement reliés à la sortie de l'oscillateur 1, à la sortie du filtre 8 et à l'entrée de signal du diviseur 9 ; pour faciliter la compréhension du dessin le commutateur 15 a été représenté comme un relais mécanique à deux positions,

- à brancher entre la sortie du filtre 8 et l'entrée de commande du commutateur 15, un détecteur de niveau 16 suivi d'un amplificateur inverseur 17; sur la figure 4 le détecteur de niveau 16 a été représenté par une diode D, en série dans la liaison filtre 8-amplificateur inverseur 17, suivie d'un condensateur C relié à la masse,
- à relier la sortie de l'amplificateur inverseur 17 à la seconde entrée d'un multiplicateur numérique 18 qui reçoit sur sa première entrée le signal numérique Ns+1 élaboré par le microprocesseur 10 selon la figure 2,
- à relier la sortie du multiplicateur 18 à la seconde entrée d'un additionneur numérique 19 qui reçoit sur sa première entrée le signal numérique Np élaboré par le microprocesseur 10 et dont la sortie est reliée à l'entrée de commande du rapport de division du diviseur 9 ; ainsi le signal numérique Np n'est plus appliqué directement sur l'entrée de commande du diviseur 9.

Dans ce qui suit Ff est la fréquence du signal à la sortie du filtre 8 et d le signal de sortie de l'amplificateur inverseur 14, avec d=1 quand le détecteur de niveau ne repère pas la présence d'un signal à haute fréquence à la sortie du filtre 8 et d=0 quand il repère la présence d'un tel signal. L'étape d'approche est caractérisée par d=1 ; or d=1 commande le commutateur 15 pour appliquer le signal Fu de sortie de l'oscillateur 1 directement sur l'entrée du diviseur 9, sans passer par le mélangeur 7 et le filtre 8; de même d=1 fait que le signal numérique Ns+1 est appliqué par le multiplicateur 18 sur la seconde entrée de l'additionneur 19 et donc que le rapport de division du diviseur 9 est porté à Np+Ns+1 alors qu'il passe à la valeur Np après l'étape d'approche, c'est-à-dire quand d passe à 0.

Pendant l'étape d'approche, le diviseur 9 recevant directement le signal Fu et son rapport de division étant Np+Ns+1, la fréquence effective de l'oscillateur 1 tend vers (Ns+Np+1)Fr et, comme Ff=Fu-Fn, la fréquence effective du signal à la sortie du filtre 8 tend vers

$$(Np+Ns+1)Fr - \left(Ns+\frac{K}{M}\right)Fr = \left(Np+\frac{M-K}{M}\right)Fr$$

avec $0 \leq K \leq M-1$ comme il a été vu plus avant.

Ainsi l'oscillateur 1 s'approche de sa valeur programmée.

La différence ΔFu entre la valeur effective et la valeur programmée de la fréquence de l'oscillateur 1 tend vers la différence entre la valeur d'approche et la valeur programmée de la fréquence de l'oscillateur 1 :

$$\Delta Fu \Rightarrow (Np+Ns+1)Fr - \left(Np+Ns+\frac{K}{M}\right)Fr = Fr - \frac{K}{M}Fr$$

ce qui entraîne

$$\frac{Fr}{M} \leq \Delta Fu \leq Fr \qquad (1a)$$

et donc

$$0 < \Delta Fu \leq Fr \qquad (2a)$$

les valeurs limites de (1a) correspondent respectivement à K=M-1 et K=0.

Du fait que Fu s'approche de sa valeur programmée, la fréquence du signal haute fréquence à la sortie du filtre 8 s'approche de sa valeur finale Fd. La différence ΔFf entre la valeur effective et la valeur finale de la fréquence à la sortie du filtre 8, tend vers la différence entre la valeur d'approche et la valeur finale du signal de sortie du filtre 8 :

$$\Delta Ff \Rightarrow \left(Np+\frac{M-K}{M}\right)Fr - Np.Fr = \frac{M-K}{M}Fr$$

ce qui entraîne

$$\frac{Fr}{M} \leq \Delta Ff \leq Fr \tag{1b}$$

et donc

$$0 < \Delta f \leq Fr \tag{2b}$$

les valeurs limites de (1b) correspondent respectivement à K=M-1 et K=0.

La fréquence à la sortie du filtre 8 s'approche de sa valeur de prépositionnement. La différence $\Delta Fp$ entre la valeur effective et la valeur prépositionnée de la fréquence à la sortie du filtre 8 tend donc vers la différence entre la valeur d'approche et la valeur prépositionnée de la fréquence du signal de sortie du filtre 8 :

$$\Delta Fp \Rightarrow \left(Np + \frac{M-K}{M}\right)Fr - \left(Np + \frac{1}{2}\right)Fr = \left(\frac{M-K}{M} - \frac{1}{2}\right)Fr$$

ce qui entraîne

$$-\frac{Fr}{2} + \frac{Fr}{M} \leq \Delta Fp \leq +\frac{Fr}{2} \tag{1c}$$

et donc

$$-\frac{Fr}{2} < \Delta Fp \leq +\frac{Fr}{2} \tag{2c}$$

les valeurs limites de (1c) correspondent respectivement à K=M-1 et K=0.

Ainsi la capacité de rattrapage du dispositif d'approche correspond à la bande de fréquences couverte par un prépositionnement donné, $\pm\frac{Fr}{2}$, du filtre 8.

En fait il n'est pas nécessaire d'atteindre ces limites, car, dès que le niveau devient suffisant à la sortie du filtre 8, le synthétiseur se reconfigure dans sa structure initiale par basculement du commutateur 15 sur la sortie du filtre 8.

Différentes autres variantes peuvent être trouvées sans sortir du cadre de l'invention; en particulier les éléments du montage peuvent être réglés pour que, dans la boucle, ce soit la composante Fu+Fn du signal de sortie du mélangeur 7 qui soit prise en compte. Et il est à noter que si tout au long de la description il a été considéré que K pouvait varier de 0 à M-1 il est aussi possible, comme d'ailleurs avec les boucles selon la figure 1, de donner à K une valeur entière pouvant varier de 0 à -M+1 sous réserve de régler en conséquence les autres éléments du synthétiseur.

D'une manière générale le domaine de l'invention s'étend à tout synthétiseur à boucle unique, quelle que soit cette boucle, qui comporte un mélangeur de fréquences et un dispositif de synthèse numérique directe, quel que soit ce dispositif, et dans lequel le mélangeur est inséré dans la boucle pour y introduire le signal élaboré par le dispositif.

L'invention trouve son application dans les ensembles électroniques équipés de synthétiseurs nécessitant une grande agilité dans l'élaboration de leur fréquence de sortie.

## Revendications

1.    Synthétiseur de fréquences à boucle unique (1, 4, 6, 7, 8, 9) pour fournir une fréquence synthétisée pouvant s'écrire

$$\left(N + \frac{K}{M}\right)Fr$$

où Fr est une fréquence, N, K et M des nombres entiers avec N et M positifs et K inférieur à M en valeur absolue, ce synthétiseur comportant un oscillateur de référence (5) pour fournir un signal à la fréquence Fr, caractérisé en ce qu'il comporte un mélangeur (7) avec une première et une seconde entrée et une sortie et un dispositif de synthèse numérique directe (21, 22, 23), en ce que le mélangeur est disposé en série dans la boucle par sa première entrée et sa sortie et en ce que le dispositif de synthèse numérique directe à une sortie reliée à la seconde entrée du mélangeur et élabore, à partir du signal à fréquence Fr, un signal de fréquence

$$\left(Ns + \frac{K}{M}\right) Fr$$

où Ns est un entier positif petit devant N.

2. Synthétiseur selon la revendication 1, caractérisé en ce qu'il comporte, en série dans sa boucle, un comparateur de phases (4) ayant une première entrée pour recevoir le signal à fréquence Fr et une seconde entrée, un filtre passe-bas (6), une entrée de commande d'un oscillateur variable, l'oscillateur variable (1), une première entrée d'un mélangeur ayant une seconde entrée, le mélangeur (7), un filtre passe-bande réglable (8), un diviseur de fréquences réglable (9) et la seconde entrée du comparateur et en ce que le dispositif de synthèse numérique directe (21, 22, 23) est relié à la seconde entrée du mélangeur.

3. Synthétiseur selon la revendication 2, caractérisé en ce que le filtre réglable (8) est réglé en fonction de la seule valeur Np, où Np=N-Ns.

4. Synthétiseur selon la revendication 2, caractérisé en ce que le filtre réglable (8) est réglé en fonction de la valeur Np, où Np=N-Ns, et de la valeur du signal de sortie du filtre passe-bas (6) et comporte pour cela un additionneur (12) ayant une sortie pour commander le réglage du filtre réglable (8), une première entrée pour recevoir un signal fonction de Np et une seconde entrée couplée à une sortie du filtre passe-bas (6).

5. Synthétiseur selon l'une des revendications 2 à 4, caractérisé en ce qu'il comporte un premier dispositif de commutation (15) pour couper la boucle entre le filtre passe-bande réglable (8) et le diviseur (9) et refermer la boucle ainsi coupée par une liaison directe entre l'oscillateur (1) et le diviseur (9), un second dispositif de commutation (18, 19) pour faire passer le rapport de division du diviseur (9) de la valeur Np=N-Ns à une valeur fonction de N, et un détecteur de niveau (16) en aval du filtre passe-bande (8) pour commander le premier (15) et le second (18, 19) dispositif de commutation.

6. Ensemble électronique, caractérisé en ce qu'il comporte au moins un synthétiseur selon l'une des revendications précédentes.

## Patentansprüche

1. Einzelschleifen-Frequenzsynthetisierer (1, 4, 6, 7, 8, 9) zum Liefern einer synthetisierten Frequenz, die durch (N + K/M) Fr ausgedrückt werden kann, wobei Fr eine Frequenz ist und N, K und M ganze Zahlen sind, wobei N und M positiv sind und K dem Absolutwert nach kleiner als M ist, wobei dieser Synthetisierer einen Referenzoszillator (5) enthält, der ein Signal mit der Frequenz Fr liefert, dadurch gekennzeichnet, daß er einen Mischer (7) mit einem ersten und einem zweiten Eingang und einem Ausgang sowie eine Vorrichtung (21, 22, 23) zur direkten numerischen Synthese enthält, daß der Mischer in der Schleife mit seinem ersten Eingang und seinem Ausgang in Serie geschaltet ist und daß die Vorrichtung zur direkten numerischen Synthese einen mit dem zweiten Eingang des Mischers verbundenen Ausgang besitzt und anhand des Frequenzsignals Fr ein Frequenzsignal (Ns + K/M) Fr erzeugt, wobei Ns eine im Vergleich zu N kleine positive ganze Zahl ist.

2. Synthetisierer nach Anspruch 1, dadurch gekennzeichnet, daß er in seiner Schleife in Serie einen Phasenkomparator (4), der einen ersten Eingang für den Empfang des Signals mit Frequenz Fr und einen zweiten Eingang enthält, ein Tiefpaßfilter (6), einen Steuereingang eines variablen Oszillators, einen variablen Oszillator (1), einen ersten Eingang eines einen zweiten Eingang besitzenden Mischers, den Mischer (7), ein einstellbares Bandpaßfilter (8), einen einstellbaren Frequenzteiler (9) und den zweiten Eingang des Komparators enthält und daß die Vorrichtung (21, 22, 23) zur direkten numerischen Synthese mit dem zweiten Eingang des Mischers verbunden ist.

3. Synthetisierer nach Anspruch 2, dadurch gekennzeichnet, daß das einstellbare Filter (8) in Abhängigkeit nur vom Wert Np eingestellt wird, wobei Np = N - Ns ist.

4. Synthetisierer nach Anspruch 2, dadurch gekennzeichnet, daß das einstellbare Filter (8) in Abhängigkeit vom Wert Np, wobei Np = N - Ns ist, und vom Wert des Ausgangssignals des Tiefpaßfilters (6) eingestellt wird und hierzu einen Addierer (12) enthält, der einen Ausgang zum Steuern der Einstellung des einstellbaren Filters (8), einen ersten Eingang für den Empfang eines von Np abhängenden Signals und einen mit einem Ausgang des Tiefpaßfilters (6) verbundenen zweiten Eingang besitzt.

5. Synthetisierer nach einem der Ansprüche 2 bis 4, dadurch gekennzeichnet, daß er eine erste Schaltvorrichtung (15) zum Unterbrechen der Schleife zwischen dem einstellbaren Bandpaßfilter (8) und dem Teiler (9) und zum Schließen der so unterbrochenen Schleife durch eine direkte Verbindung zwischen dem Oszillator (1) und dem Teiler (9), eine zweite Schaltvorrichtung (18, 19) zum Verschieben des Teilungsverhältnisses des Teilers (7) vom Wert Np = N - Ns zu einem von N abhängenden Wert sowie einen Pegeldetektor (16) hinter dem Bandpaßfilter (8) zum Steuern der ersten (15) und der zweiten (18, 19) Schaltvorrichtung enthält.

6. Elektronische Anordnung, dadurch gekennzeichnet, daß sie wenigstens einen Synthetisierer nach einem der vorangehenden Ansprüche enthält.

## Claims

1. Single-loop frequency synthesizer (1, 4, 6, 7, 8, 9) for providing a synthesized frequency which can be written

$$\left( N + \frac{K}{M} \right) \ \texttt{Fr}$$

where Fr is a frequency, N, K and M are integers with N and M positive and K less than M in absolute value, this synthesizer comprising a reference oscillator (5) for providing a signal at the frequency Fr, characterized in that it comprises a mixer (7) with a first and a second input and an output and a direct digital synthesis device (21, 22, 23), in that the mixer is arranged in series in the loop via its first input and its output and in that the direct digital synthesis device has an output linked to the second input of the mixer and produces, from the signal with frequency Fr, a signal of frequency

$$\left( Ns + \frac{K}{M} \right) \ \texttt{Fr}$$

where Ns is a positive integer which is small compared with N.

2. Synthesizer according to Claim 1, characterized in that it comprises, in series in its loop, a phase comparator (4) having a first input for receiving the signal with frequency Fr and a second input, a low-pass filter (6), a control input for a variable oscillator, the variable oscillator (1), a first input of a mixer having a second input, the mixer (7), an adjustable bandpass filter (8), an adjustable frequency divider (9) and the second input of the comparator and in that the direct digital synthesis device (21, 22, 23) is linked to the second input of the mixer.

3. Synthesizer according to Claim 2, characterized in that the adjustable filter (8) is adjusted as a function solely of the value Np, where Np=N-Ns.

4. Synthesizer according to Claim 2, characterized in that the adjustable filter (8) is adjusted as a function of the value Np, where Np=N-Ns, and of the value of the output signal from the low-pass filter (6) and includes for this purpose an adder (12) having an output for controlling the adjusting of the adjustable filter (8), a first input for receiving a signal dependent on Np and a second input coupled to an output of the low-pass filter (6).

5. Synthesizer according to one of Claims 2 to 4, characterized in that it comprises a first switching device (15) for cutting the loop between the adjustable bandpass filter (8) and the divider (9) and for closing the loop thus cut by a direct link between the oscillator (1) and the divider (9), a second switching device (18, 19) for causing the division ratio of the divider (9) to go from the value Np=N-Ns to a value dependent on N, and a level detector (16) downstream of the bandpass filter (8) for controlling the first (15) and the second (18, 19) switching device.

6. Electronic assembly, characterized in that it comprises at least one synthesizer according to one of the preceding claims.

FIG.1
ART
ANTERIEUR

FIG.2

FIG.3

FIG.4